# EUROPEAN PATENT APPLICATION

(11) **EP 4 354 164 A1**
(43) Date of publication of application: **17.04.2024**
(21) Application number: 22820154.7
(22) Date of filing: 03.06.2022
(51) Int. Cl.: G01R 31/389, G01R 31/367, H01M 10/48, H02J 7/00

(54) **BATTERY ABNORMALITY DETECTING DEVICE, AND BATTERY ABNORMALITY DETECTING METHOD**

(30) Priority: 07.06.2021 JP 2021095357
(71) Applicant: Nuvoton Technology Corporation Japan, Nagaokakyo City Kyoto 617-8520 (JP)
(72) Inventor: KAWABE, Akira, Nagaokakyo City, Kyoto 617-8520 (JP); KOBAYASHI, Hitoshi, Nagaokakyo City, Kyoto 617-8520 (JP); FUJII, Keiichi, Nagaokakyo City, Kyoto 617-8520 (JP)
(74) Representative: Novagraaf International SA
(86) International application number: PCT/JP2022/022607
(87) International publication number: WO 2022/259973

(57) **Abstract**

A battery anomaly detection device (100) includes: an alternating-current (AC) impedance measurer (110) that measures AC impedance of a battery cell; and an anomaly determiner (120) that determines whether the AC impedance is within a reference range, and when the AC impedance is not within the reference range, determines that the battery cell is an anomalous cell. For example, the AC impedance measurer (110) measures AC impedances (Z1 through Z8) of a plurality of battery cells that are directly connected to each other, and the anomaly determiner (120): calculates the reference range from the measured AC impedances (Z1 through Z8); and determines whether each of the AC impedances (Z1 through Z8) is within the reference range, and determines that the battery cell whose AC impedance is not within the reference range is an anomalous cell.

## Description

### [Technical Field]

The present invention relates to battery anomaly detection devices and battery anomaly detection methods.

### [Background Art]

In recent years, vehicles such as hybrid electric vehicles (HEVs) and electric vehicles (EVs) which travel using secondary batteries as a power supply have been developed. Lithium-ion batteries (LiBs) are used as secondary batteries, for example. To use such secondary batteries safely, a battery management system (BMS) is used.

Patent Literature (PTL) 1 describes using an alternating-current (AC) impedance method for measuring voltage and current while causing a battery to sweep an AC signal, to measure the internal temperature of the battery.

### [Citation List]

### [Patent Literature]

[PTL 1] Japanese Patent No. 5261622

### [Summary of Invention]

### [Technical Problem]

The present disclosure has an object to provide a battery anomaly detection device and a battery anomaly detection method that can achieve highly accurate battery anomaly detection.

### [Solution to Problem]

A battery anomaly detection device according to one aspect of the present disclosure includes: an alternating-current (AC) impedance measurer that measures AC impedance of a battery cell; and an anomaly determiner that determines whether the AC impedance is within a reference range, and when the AC impedance is not within the reference range, determines that the battery cell is an anomalous cell.

### [Advantageous Effects of Invention]

The present disclosure can provide a battery anomaly detection device and a battery anomaly detection method that can achieve highly accurate battery anomaly detection.

### [Brief Description of Drawings]

[FIG. 1]

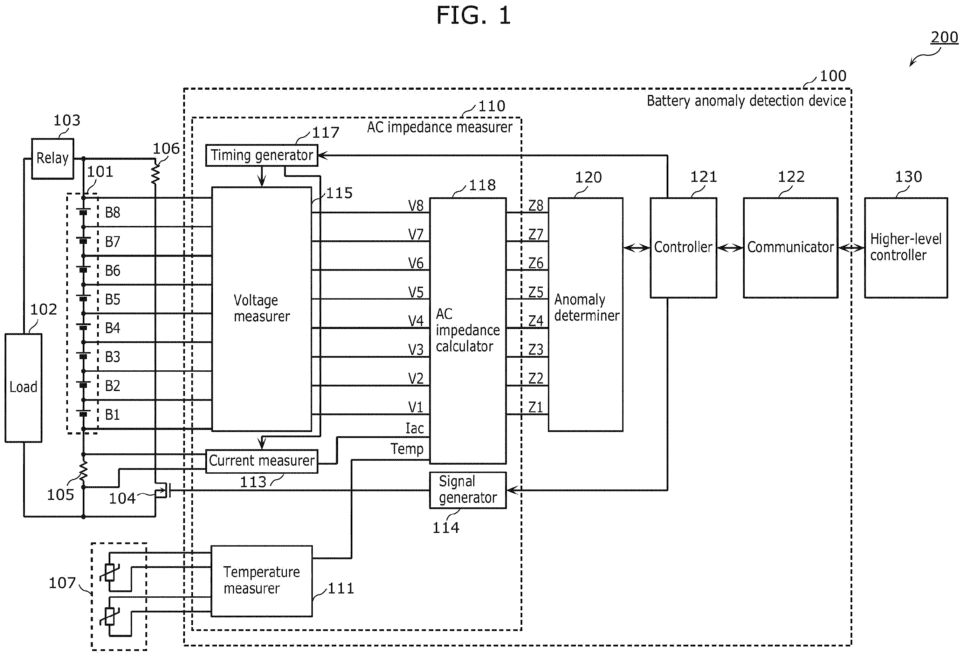

   FIG. 1 is a block diagram illustrating a battery anomaly detection system according to Embodiment 1.
[FIG. 2]

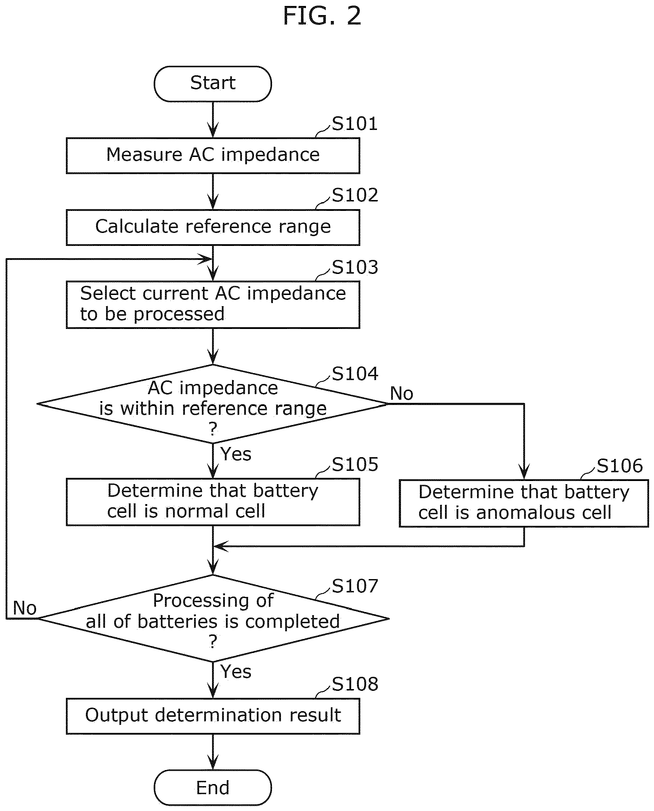

   FIG. 2 is a flowchart illustrating a battery anomaly detection process according to Embodiment 1.
[FIG. 3]

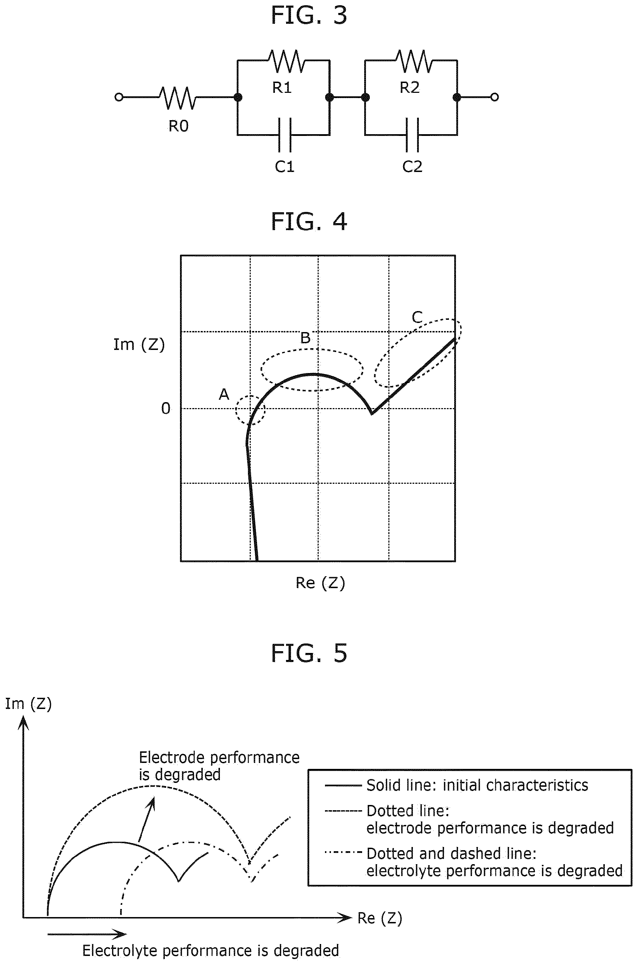

   FIG. 3 is a diagram illustrating the equivalent circuit of a battery according to Embodiment 1.
[FIG. 4]
   FIG. 4 is a diagram illustrating the AC impedance of the battery according to Embodiment 1.
[FIG. 5]
   FIG. 5 is a diagram illustrating the relationship between a change in the AC impedance of the battery according to Embodiment 1 and battery degradation.
[FIG. 6]

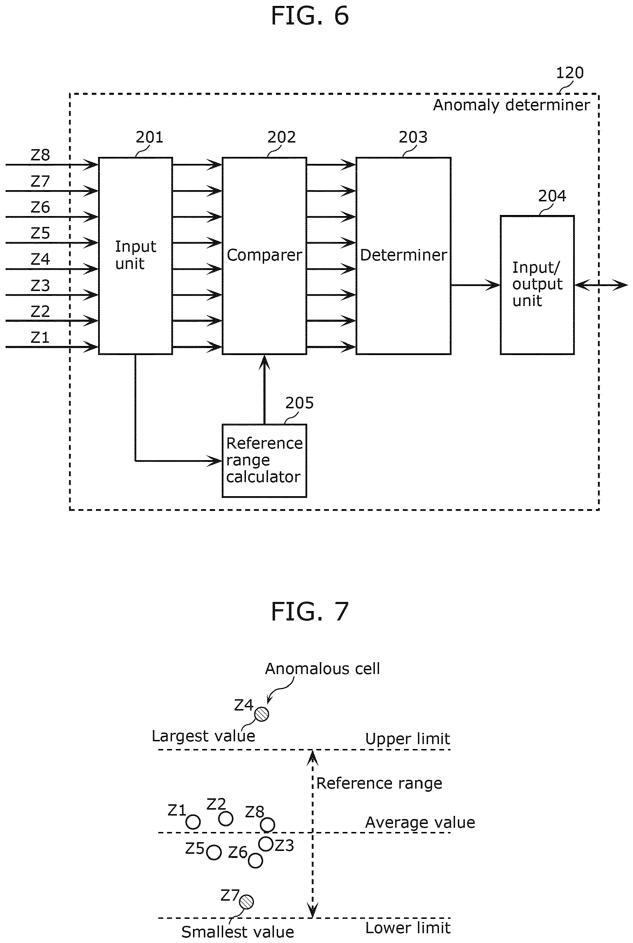

   FIG. 6 is a block diagram illustrating an anomaly determiner according to Embodiment 1.
[FIG. 7]
   FIG. 7 is a diagram illustrating a specific example of an anomalous cell determination process according to Embodiment 1.
[FIG. 8]

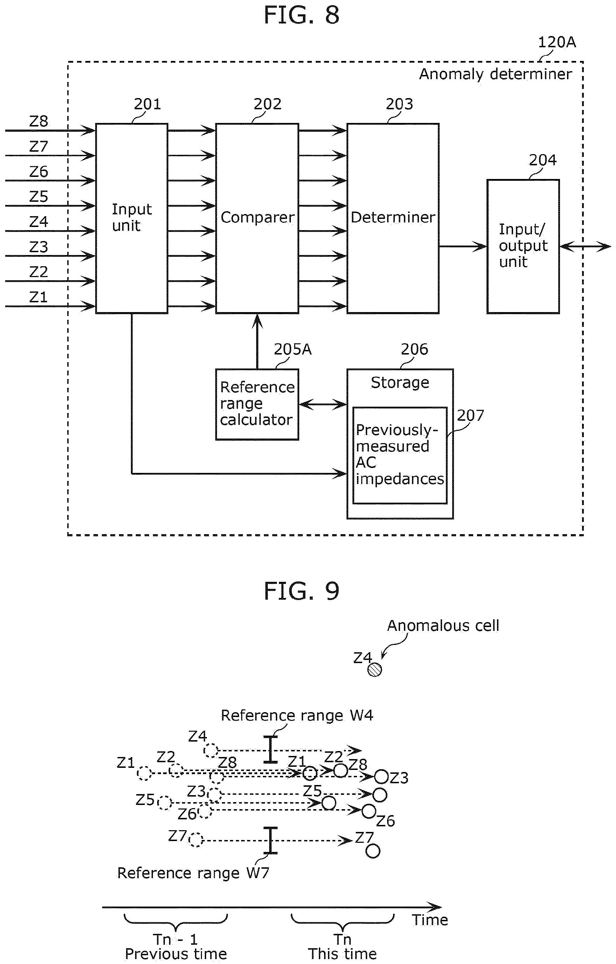

   FIG. 8 is a block diagram illustrating an anomaly determiner according to Embodiment 2.
[FIG. 9]
   FIG. 9 is a diagram illustrating a specific example of an anomalous cell determination process according to Embodiment 2.
[FIG. 10]

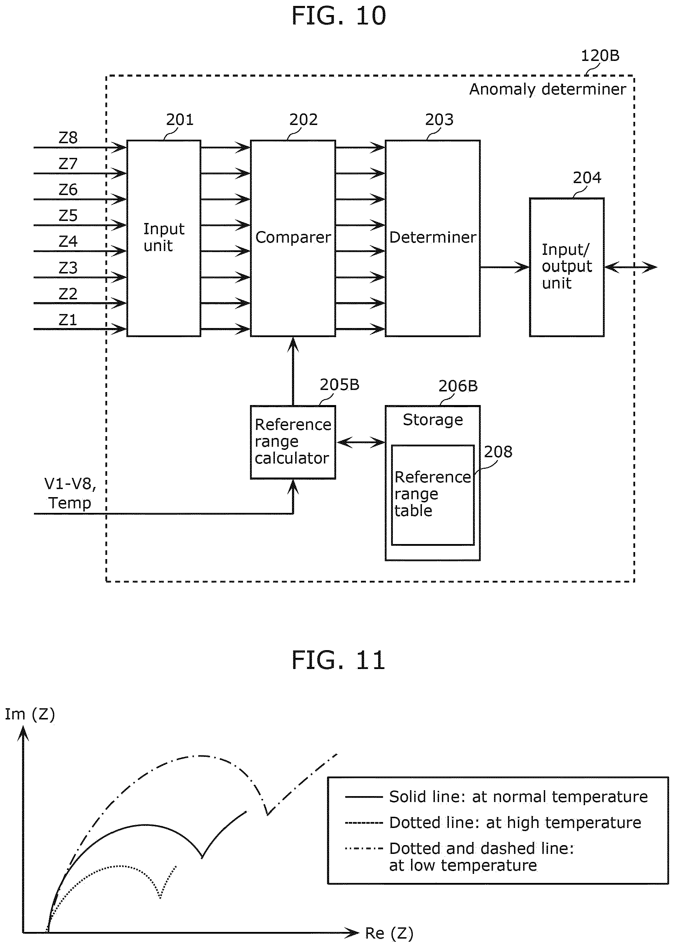

   FIG. 10 is a block diagram illustrating an anomaly determiner according to Embodiment 3.
[FIG. 11]
   FIG. 11 is a diagram illustrating an example of temperature dependency of AC impedance according to Embodiment 3.
[FIG. 12]

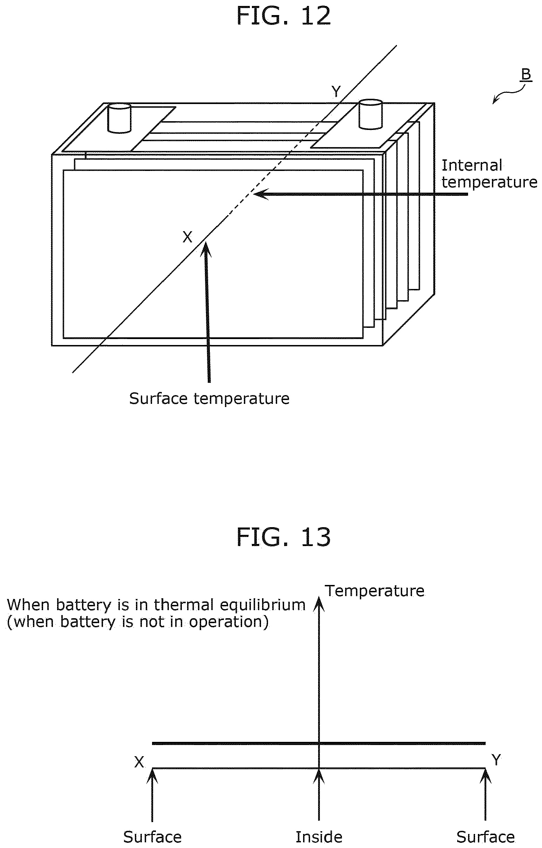

   FIG. 12 is a diagram illustrating the outer appearance of a battery according to Embodiment 3.
[FIG. 13]
   FIG. 13 is a diagram illustrating the internal temperature of the battery according to Embodiment 3 when the battery is in thermal equilibrium.
[FIG. 14]

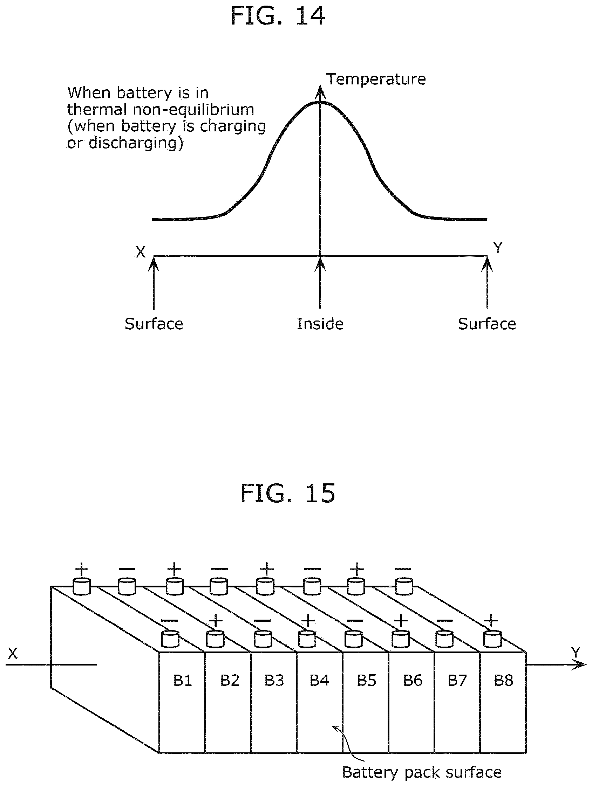

   FIG. 14 is a diagram illustrating the internal temperature of the battery according to Embodiment 3 when the battery is in thermal non-equilibrium.
[FIG. 15]
   FIG. 15 is a diagram illustrating the outer appearance of a battery pack according to Embodiment 3.
[FIG. 16]

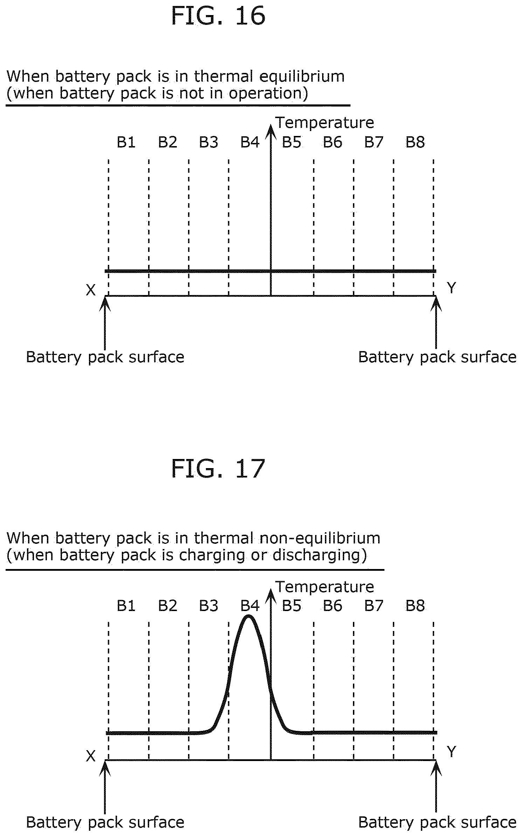

   FIG. 16 is a diagram illustrating the internal temperature of the battery pack according to Embodiment 3 when the battery pack is in thermal equilibrium.
[FIG. 17]
   FIG. 17 is a diagram illustrating the internal temperature of the battery pack according to Embodiment 3 when the battery pack is in thermal non-equilibrium.
[FIG. 18]

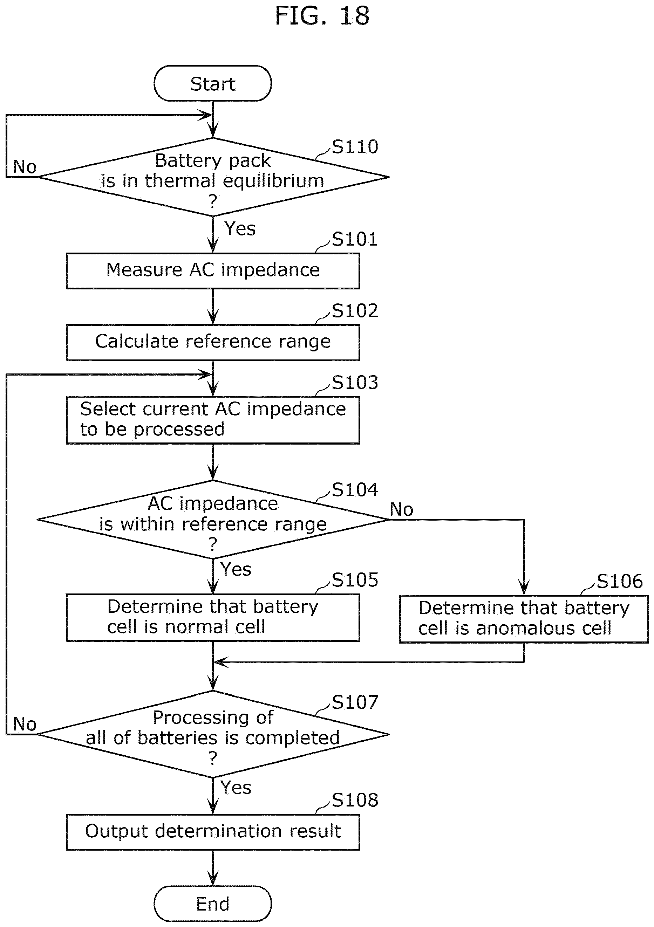

   FIG. 18 is a flowchart illustrating a battery anomaly detection process according to Embodiment 3.
[FIG. 19]

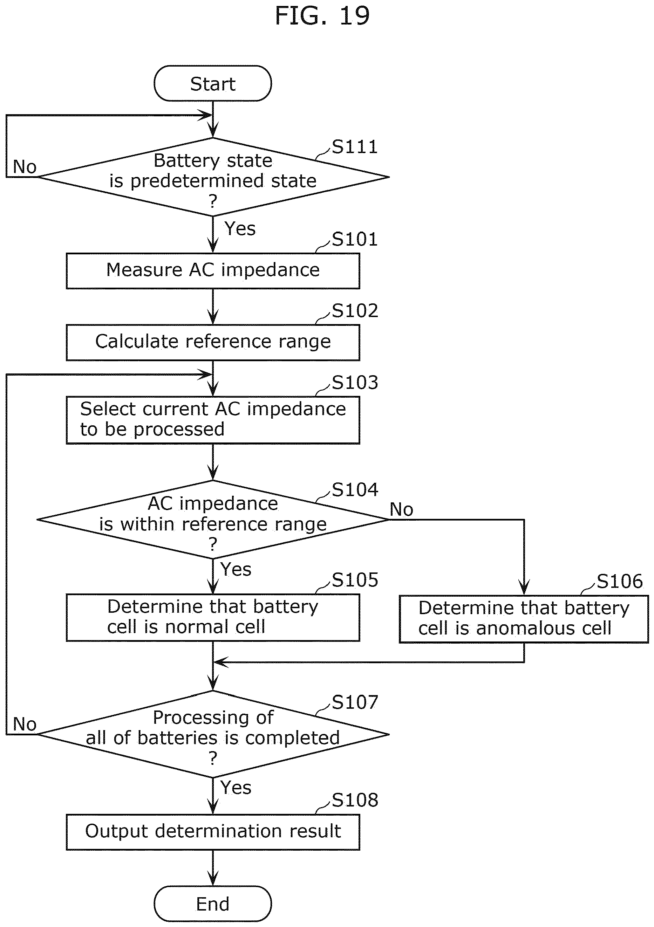

   FIG. 19 is a flowchart illustrating another battery anomaly detection process according to Embodiment 3.
[FIG. 20]

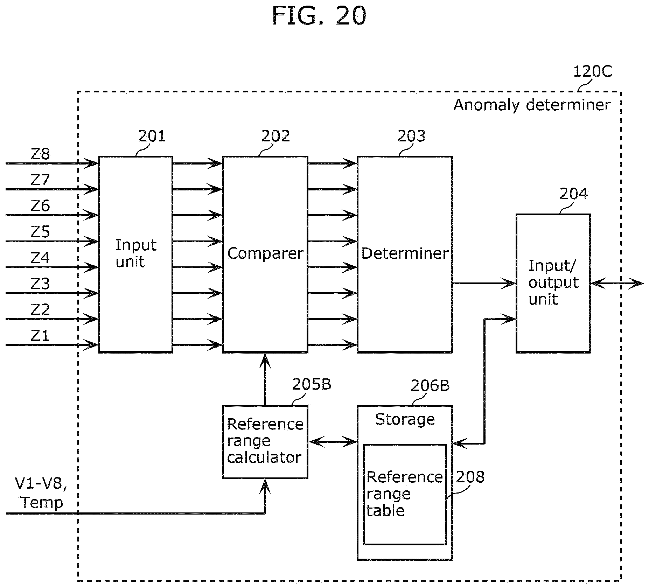

   FIG. 20 is a block diagram illustrating an anomaly determiner according to Embodiment 4.
[FIG. 21]

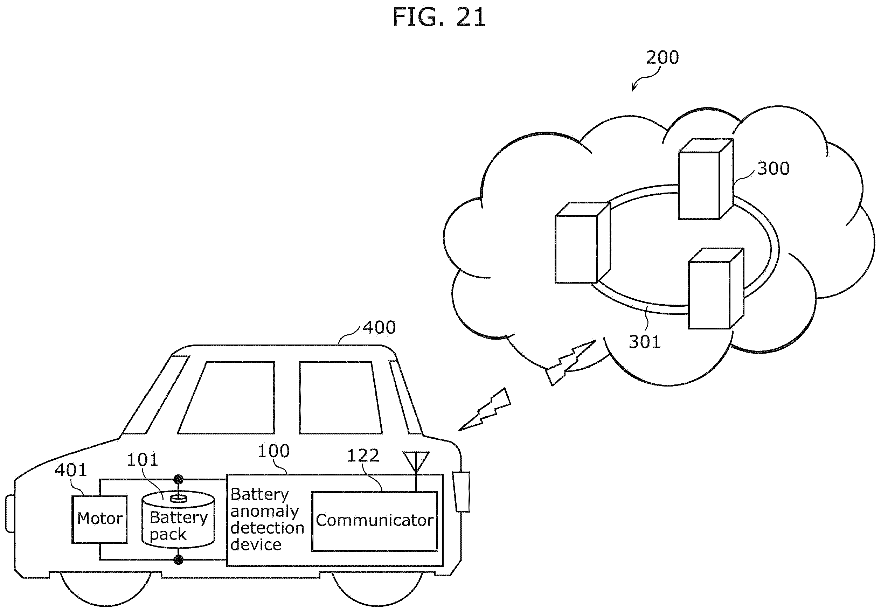

   FIG. 21 is a diagram illustrating the outline of a battery anomaly detection system according to Embodiment 4.

### [Description of Embodiments]

### (Underlying Knowledge Forming Basis of the Present Disclosure)

In recent years, applications that use secondary batteries, such as storage batteries for stably supplying renewable energy as well as environment-friendly vehicles including electric vehicles, have been increasing rapidly. In many cases, lithium-ion batteries are used as such secondary batteries for their high energy density. A lithium-ion battery is known for its degradation that accelerates due to overcharge, overdischarge, and temperature of the battery which could lead to dangerous conditions such as smoke ignition and explosion in the worst cases. Such a lithium-ion battery is therefore integrated into a BMS and appropriate control is performed.

In general, a BMS monitors voltages, currents, and temperatures of all of battery cells included in a battery pack, and monitors the states of the battery cells using measurement data resulting from the monitoring. The currents of all the battery cells can be obtained in a single manner by monitoring the charging or discharging current of the entire battery pack. Moreover, thermistors for measurement are placed at the battery pack to obtain the temperatures of all the battery cells. However, due to restrictions in locations to place thermistors and the number of thermistors, estimation values with consideration given to a temperature distribution are normally obtained in many cases. Since temperatures outside the battery case are obtained, errors need to be considered when such temperatures are treated as cell temperatures.

It is desired that such a BMS can detect an anomaly in a battery with high accuracy in order to enhance safety.

A battery anomaly detection device according to one aspect of the present disclosure includes: an alternating-current (AC) impedance measurer that measures AC impedance of a battery cell; and an anomaly determiner that determines whether the AC impedance is within a reference range, and when the AC impedance is not within the reference range, determines that the battery cell is an anomalous cell.

According to this, the battery anomaly detection device can detect an anomaly in a battery cell using an AC impedance value per se. This enables the battery anomaly detection device to achieve highly accurate battery anomaly detection.

For example, the AC impedance measurer may measure AC impedance of each of a plurality of battery cells that include the battery cell and are directly connected to each other, and the anomaly determiner may: calculate the reference range from the measured AC impedances; and determine whether each of the AC impedances is within the reference range, and determine that the battery cell whose AC impedance is not within the reference range is an anomalous cell.

For example, the anomaly determiner may: exclude the largest value and the smallest value from the measured AC impedances; calculate the average value of the remaining AC impedances after the exclusion of the largest value and the smallest value; and calculate the reference range based on the average value.

For example, the battery anomaly detection device may further include storage that stores a previously-measured AC impedance. The anomaly determiner may determine the reference range based on the previously-measured AC impedance.

For example, the anomaly determiner may determine, as the reference range, a range corresponding to the current first battery state of the battery cell among a plurality of ranges that are associated in advance with a plurality of first battery states, and the plurality of first battery states may each include at least one of a temperature, a voltage, or a state of charge (SOC) of the battery cell.

For example, the battery anomaly detection device may further include a communicator that communicates with a server device via a communication network. The reference range may be obtained from the server device.

For example, the AC impedance measurer may measure the AC impedance of the battery cell when the battery cell is in thermal equilibrium.

For example, the AC impedance measurer may measure the AC impedance of the battery cell when the battery cell is in a second battery state that is predetermined, and the second battery state may include at least one of a temperature, a voltage, or a state of charge (SOC) of the battery cell.

A battery anomaly detection method according to one aspect of the present disclosure includes: measuring alternating-current (AC) impedance of a battery cell; determining whether the AC impedance is within a reference range; and when the AC impedance is not within the reference range, determining that the battery cell is an anomalous cell.

According to this, the battery anomaly detection method allows achieving the detection of an anomaly in a battery cell using an AC impedance value per se. With this, the battery anomaly detection method allows achieving highly accurate battery anomaly detection.

Note that these general or specific aspects may be achieved by a system, a method, an integrated circuit, a computer program, a computer-readable recording medium such as a CD-ROM, or any combination thereof.

Hereinafter, embodiments of the present disclosure will be described in detail with reference to the drawings. Note that each of the embodiments described below shows a specific example of the present disclosure. Numerical values, shapes, materials, elements, the arrangement and connection of the elements, steps, orders of steps, etc., indicated in the following embodiments are merely examples, and do not intend to limit the present disclosure.

The figures are schematic diagrams and are not necessarily precise illustrations. Elements that are essentially the same share like reference signs in the figures, and duplicate description is omitted or simplified.

### [Embodiment 1]

First, a battery anomaly detection system and a battery anomaly detection device according to the present embodiment will be described. FIG. 1 is a block diagram illustrating battery anomaly detection system 200 according to the present embodiment. Battery pack 101 includes batteries B1 through B8 (hereinafter, any one of batteries B1 through B8 is referred to as battery B). Stated differently, battery B is a battery cell. Battery B is specifically a lithium-ion battery, but may be any other battery such as a nickel metal hydride battery. Battery pack 101 functions as the power supply of load 102 and supplies power to load 102. Load 102 is, for example, the motor of an EV, but is not particularly limited. A battery charger for charging battery pack 101, instead of load 102, may be connected at the location of load 102.

Battery anomaly detection system 200 includes relay 103, transistor 104, reference resistance 105, load resistance 106, temperature sensor 107, battery anomaly detection device 100, and higher-level controller 130.

Relay 103 is connected between battery pack 101 and load 102. Transistor 104 is, for example, a field effect transistor (FET), but may be a bipolar transistor. The drain of transistor 104 is connected to load resistance 106, the source of transistor 104 is connected to reference resistance 105, the gate (i.e., control terminal) of transistor 104 is connected to signal generator 114.

Battery anomaly detection device 100 is included in, for example, a BMS. Battery anomaly detection device 100 includes AC impedance measurer 110, anomaly determiner 120, controller 121, and communicator 122. Battery anomaly detection device 100 includes, for example, one or more integrated circuits. The functions of anomaly determiner 120 and the functions of controller 121 may be implemented by a processor executing a program, by a dedicated circuit, or by a combination thereof.

AC impedance measurer 110 measures AC impedances Z1 through Z8 of battery pack 101. Anomaly determiner 120 determines whether an anomaly is detected in each of batteries B included in battery pack 101 using AC impedances Z1 through Z8.

AC impedance measurer 110 includes temperature measurer 111, current measurer 113, signal generator 114, voltage measurer 115, timing generator 117, and AC impedance calculator 118.

Temperature measurer 111 measures temperature Temp of temperature sensor 107. Temperature sensor 107 is a temperature sensor that uses a thermistor, but may be a temperature sensor that uses any other element such as a thermocouple.

Current measurer 113 measures current iMac that flows through reference resistance 105. Specifically, current measurer 113 measures current Iac by measuring voltages at both ends of reference resistance 105. Signal generator 114 applies a control signal to the control terminal of transistor 104. The control signal can be set to any frequency and is characterized in applying an AC signal to a closed circuit including battery pack 101, load resistance 106, transistor 104, and reference resistance 105.

Voltage measurer 115 measures voltages V1 through V8 of batteries B1 through B8 included in battery pack 101. Voltage measurer 115 includes, for example, AD converters. Timing generator 117 controls the measurement timings of currents measured by current measurer 113 and the measurement timings of voltages measured by voltage measurer 115.

AC impedance calculator 118 calculates AC impedances Z1 through Z8 of batteries B1 through B8 based on current Iac measured by current measurer 113 and voltages V1 through V8 measured by voltage measurer 115. Specifically, AC impedance calculator 118 calculates AC impedance Zn of battery Bn by dividing voltage Vn by current Iac. Here, n is any one of 1 to 8. Each of the AC impedances is a complex number an¥d has real component Zre and imaginary component Zim.

Anomaly determiner 120 detects an anomalous cell in batteries B using AC impedances Z1 through Z8. In other words, anomaly determiner 120 determines whether each of batteries B is an anomalous cell. An anomalous cell is a battery cell that is not in a normal state and needs to be replaced, for example. Anomaly determiner 120 also notifies higher-level controller 130 of the determination result via controller 121 and communicator 122.

Controller 121 controls, for instance, AC impedance measurer 110. Communicator 122 communicates with battery anomaly detection device 100 and higher-level controller 130. Higher-level controller 130 controls the entire battery pack. When battery anomaly detection system 200 is installed in a vehicle, for example, higher-level controller 130 may perform vehicle control, for instance.

Next, the flow of an operation performed by battery anomaly detection device 100 will be described. FIG. 2 is a flowchart illustrating a battery anomaly detection process performed by battery anomaly detection device 100. First, AC impedance measurer 110 measures AC impedances Z1 through Z8 (S101).

Specifically, signal generator 114 generates a control signal having frequency components and applies the generated control signal to the control terminal of transistor 104. Subsequently, current measurer 113 measures current Iac flowing through reference resistance 105. Subsequently, voltage measurer 115 measures voltages V1 through V8 of batteries B1 through B8. Then, AC impedance calculator 118 calculates AC impedances Z1 through Z8 of batteries B1 through B8 based on the measured current Iac and the measured voltages V1 through V8.

Specifically, AC impedance calculator 118 converts currents Iac to complex currents and converts voltages V1 through V8 to complex voltages. AC impedance calculator 118 performs an averaging process of averaging complex currents and an averaging process of averaging complex voltages, and calculates AC impedance by dividing a complex voltage resulting from the complex voltage averaging process by a complex current resulting from the complex current averaging process. For example, impedance real portion Z1re and impedance imaginary portion Z1im are output as the AC impedance of battery B1. AC impedance calculator 118 may correct the AC impedance based on temperature Temp measured by temperature measurer 111.

FIG. 3 is a diagram illustrating an example of a battery model that is the equivalent circuit of battery B. It is conceivable, as can be seen from FIG. 3, that battery B has a circuit configuration in which the following are series connected to each other: resistance R0; resistance R1 and capacitor element C1 connected in parallel; and resistance R2 and capacitor element C2 connected in parallel. In the example here, a battery model is presented as including three resistances and two capacitors, but the number of resistances and the number of capacitors are not limited to this example. For example, a battery model may be presented as including four or more resistances and three or more capacitors. Moreover, the number of resistances may be same as or different from the number of capacitors.

FIG. 4 is a diagram illustrating the AC impedance of battery B. FIG. 4 is a diagram referred to as a Cole-Cole plot and is also referred to as a Nyquist plot. The characteristics of area A illustrated in the diagram depend on R0 illustrated in FIG. 3, the characteristics of area B depend on R1 and C1, and the characteristics of area C depend on R2 and C2.

A battery model parameter changes due to battery B being degraded. In other words, the AC impedance of battery B changes due to the degradation of battery B. FIG. 5 is a diagram illustrating the relationship between a change in the AC impedance of battery B and the degradation of battery B. The AC impedance of battery B has initial characteristics indicated by the solid line in FIG. 5. The characteristics of the AC impedance of battery B change to the characteristics indicated by the dashed line in FIG. 5 when the electrode performance of battery B is degraded. The characteristics of the AC impedance of battery B change to the characteristics indicated by the dotted and dashed line in FIG. 5 when the electrolyte performance of battery B is degraded.

In the process in step S102 and the following processes in FIG. 2, anomaly determiner 120 determines whether each of batteries B is an anomalous cell using AC impedances Z1 through Z8. FIG. 6 is a block diagram illustrating the configuration of anomaly determiner 120. Anomaly determiner 120 includes input unit 201, comparer 202, determiner 203, input/output unit 204, and reference range calculator 205.

Input unit 201 obtains and holds AC impedances Z1 through Z8 of batteries B. Reference range calculator 205 calculates a reference range using AC impedances Z1 through Z8. Comparer 202 compares each of AC impedances Z1 through Z8 with the reference range, and determines whether the AC impedance is within the reference range. Determiner 203 determines that battery B whose AC impedance is not within the reference range is an anomalous cell. Input/output unit 204 outputs the result of the determination by determiner 203 to controller 121.

FIG. 7 is a diagram illustrating a specific example of an anomalous cell determination process. As illustrated in FIG. 2, reference range calculator 205 calculates a reference range (S102). Specifically, reference range calculator 205 excludes the largest value (Z4) and the smallest value (Z7) from AC impedances Z1 through Z8, as illustrated in FIG. 7. Reference range calculator 205 then calculates, as a reference value, the average value of the remaining AC impedances (Z1, Z2, Z3, Z5, Z6, and Z8) after the exclusion of the largest value and the smallest value.

Reference range calculator 205 may not exclude the largest value and the smallest value and may use the average value of all of AC impedances Z1 through Z8 as a reference value. Alternatively, reference range calculator 205 may exclude, from AC impedances, N AC impedances in the descending order of the AC impedances from the largest AC impedance and M AC impedances in the ascending order of the AC impedances from the smallest AC impedance, and calculate, as a reference value, the average value of the remaining AC impedances after the exclusion of the N AC impedances and the M AC impedances. N and M are each any natural number. N and M may be the same value or different values. A mean value or the like may be used instead of an average value.

Subsequently, reference range calculator 205 determines a reference range based on the reference value. The reference range is, for example, a range from the reference value - X% to the reference value + X%. X is, for example, approximately 30 to 100. Note that the upper limit of the reference range may be defined by average value + α and the lower limit of the reference range may be defined by average value - β. α and β are predetermined values. α and β may be the same value or different values.

Subsequently, comparer 202 selects a current AC impedance to be processed (S103), and determines whether the current AC impedance is within the reference range (S104). Stated differently, comparer 202 determines whether the difference between the current AC impedance and the reference value is less than a predetermined value.

When the current AC impedance is within the reference range (Yes in S104), determiner 203 determines that a current battery B that is to be processed and corresponds to the current AC impedance is a normal cell (S105). When the current AC impedance is not within the reference range (No in S104), determiner 203 determines that the current battery B is an anomalous cell (S106).

When the processing of all of batteries B is not completed (No in S107), the next AC impedance is selected (S103) and the process in step S104 and the following processes are performed in the same manner. In other words, determination is performed for each of batteries B.

In the example illustrated in FIG. 7, since AC impedance Z4 is not within the reference range, battery B4 is determined as being an anomalous cell. Other batteries B1 through B3 and B5 through B8 are determined as being normal cells. Although an example in which the determination process is performed for batteries B one by one is described herein, the determination processes of batteries B may be performed in parallel.

When the processing of all of batteries B is completed (Yes in S107), input/output unit 204 outputs the determination results to controller 121 (S108). The determination results are notified to higher-level controller 130 via controller 121 and communicator 122. When any anomalous cell is detected, higher-level controller 130, for example, displays an error message for urging, for instance, replacement of the anomalous cell.

As described above, battery anomaly detection device 100 includes: alternating-current (AC) impedance measurer 110 that measures AC impedance of a battery cell (battery B); and anomaly determiner 120 that determines whether the AC impedance is within a reference range, and when the AC impedance is not within the reference range, determines that the battery cell is an anomalous cell. This enables battery anomaly detection device 100 to detect an anomaly in a battery cell using an AC impedance value per se. Battery anomaly detection device 100 can therefore achieve highly accurate battery anomaly detection. Battery anomaly detection with higher accuracy can be achieved by, for example, detecting an anomaly in a battery cell using an AC impedance value per se in addition to the calculation of, for instance, state of charge (SOC) or state of health (SOH).

For example, AC impedance measurer 110 measures AC impedances (Z1 through Z8) of a plurality of battery cells (B1 through B7) that are directly connected to each other. Anomaly determiner 120: calculates the reference range from the measured AC impedances (Z1 through Z8); and determines whether each of the AC impedances (Z1 through Z8) is within the reference range, and determines that the battery cell whose AC impedance is not within the reference range is an anomalous cell.

For example, anomaly determiner 120: excludes the largest value and the smallest value from the measured AC impedances (Z1 through Z8); calculates the average value of the remaining AC impedances after the exclusion of the largest value and the smallest value; and calculates the reference range based on the average value.

Thus, battery anomaly detection device 100 can detect an anomaly in a battery cell by performing AC impedance measurement on all of battery cells in a battery pack and monitoring a change in the AC impedance of each of the battery cells. This allows the safety of the system to be enhanced.

In the present embodiment, a signal in the frequency range of, for example, approximately 1000 Hz is used for AC impedance measurement. This allows AC impedance measurement to be easily achieved.

### [Embodiment 2]

In the present embodiment, another example of the anomalous cell determination method will be described. FIG. 8 is a block diagram of anomalous determiner 120A according to the present embodiment. Battery anomaly detection device 100 according to the present embodiment includes anomaly determiner 120A illustrated in FIG. 8 instead of anomaly determiner 120.

Anomaly determiner 120A illustrated in FIG. 8 includes storage 206 in addition to the configuration of anomaly determiner 120 illustrated in FIG. 6. The functions of reference range calculator 205A are different from the functions of reference range calculator 205.

Storage 206 stores previously-measured AC impedances 207. Reference range calculator 205A calculates reference ranges using previously-measured AC impedances 207.

FIG. 9 is a diagram illustrating a specific example of the anomalous cell determination process according to the present embodiment. In this example, previously-measured AC impedances 207 are AC impedances Z1 through Z8 (indicated by the dotted lines in FIG. 9) measured in the previous time Tn-1. AC impedances Z1 through Z8 measured this time Tn are held by input unit 201.

Reference range calculator 205A uses AC impedances measured in the previous time Tn-1 as reference values. Specifically, for each of AC impedances Z1 through Z8 of batteries B1 through B8, the previously-measured AC impedance of battery B is used as the reference value of the AC impedance of the same battery B. In other words, previously-measured AC impedance Z1 is used as the reference value of Z1 and previously-measured AC impedance Z2 is used as the reference value of Z2.

The example here illustrates the case of using, as a reference value, AC impedance measured in the previous time, but a reference value may be calculated from AC impedances obtained through measurements in the past. For example, the average value, the mean value, the largest value, or the smallest value of the AC impedances may be used as a reference value.

Subsequently, reference range calculator 205A determines a reference range based on the reference value. The reference range is, for example, in the range from reference value - X% to reference value + X%. X is, for example, approximately 10 to 50. The upper limit of the reference range may be defined by average value + α and the lower limit of the reference range may be defined by average value - β. α and β are predetermined values. α and β may be the same value or different values.

Subsequently, comparer 202 determines whether each AC impedance is within a reference range corresponding to the AC impedance. Stated differently, comparer 202 determines whether the difference between the AC impedance and the reference value is less than a predetermined value.

When the AC impedance is within the reference range, determiner 203 determines that battery B corresponding to the AC impedance is a normal cell. When the AC impedance is not within the reference range, determiner 203 determines that battery B corresponding to the AC impedance is an anomalous cell.

In the example illustrated in FIG. 9, since AC impedance Z4 is not within reference range W4, battery B4 is determined as being an anomalous cell. Other batteries B1 through B3 and B5 through B8 are determined as being normal cells. In FIG. 9, the indication of reference ranges other than reference ranges W4 and W7 of AC impedances Z4 and Z7 is omitted.

As described above, battery anomaly detection device 100 according to the present embodiment includes storage 206 that stores previously-measured AC impedance. Anomaly determiner 120A determines a reference range based on the previously-measured AC impedance. This enables battery anomaly detection device 100 to determine an anomaly in each of batteries B using AC impedances.

### [Embodiment 3]

In the present embodiment, another example of the anomalous cell determination method will be described. FIG. 10 is a block diagram illustrating anomaly determiner 120B according to the present embodiment. Battery anomaly detection device 100 according to the present embodiment includes anomaly determiner 120B illustrated in FIG. 10 instead of anomaly determiner 120A.

The configuration of anomaly determiner 120B illustrated in FIG. 10 is different from the configuration of anomaly determiner 120A illustrated in FIG. 8, and the functions of reference range calculator 205B and the functions of storage 206B are different from the functions of reference range calculator 205A and the functions of storage 206, respectively.

Storage 206B stores reference range table 208. Reference range table 208 is a table in which a reference range is associated with a pair of temperature and voltage. AC impedance changes in accordance with temperature and voltage. FIG. 11 is a diagram illustrating an example of temperature dependency of AC impedance. As illustrated in FIG. 11, AC impedance changes in accordance with temperature.

Reference range calculator 205B determines the reference range of each AC impedance with reference to reference range table 208 based on voltages V1 through V8 and temperature Temp that correspond to when AC impedances Z1 through Z8 are measured. For example, reference range calculator 205B determines the reference range associated with voltage V1 and temperature Temp in reference range table 208 to be the reference range of AC impedance Z1. Likewise, reference range calculator 205B determines the reference range associated with voltage V2 and temperature Temp in reference range table 208 to be the reference range of AC impedance Z2.

Although an example of reference range table 208 that shows reference ranges is described herein, reference range table 208 may show reference values and reference range calculator 205B may calculate reference ranges from the reference values in the same manner as in Embodiment 1 or 2.

Subsequently, comparer 202 determines whether each AC impedance is within the reference range corresponding to the AC impedance. Stated differently, comparer 202 determines whether the difference between the AC impedance and a reference value is less than a predetermined value.

When the AC impedance is within the reference range, determiner 203 determines that battery B corresponding to the AC impedance is a normal cell. When the AC impedance is not within the reference range, determiner 203 determines that battery B corresponding to the AC impedance is an anomalous cell.

AC impedance changes also in accordance with SOC. Reference range table 208 may therefore be a table in which a reference range is associated with a combination of temperature, voltage, and SOC. In this case, reference range calculator 205B may determine a reference range using also the current SOC. At least one of temperature, voltage, or SOC may be used.

Temperature Temp obtained by temperature measurer 111 may be different from the internal temperature of battery B. FIG. 12 is a diagram illustrating the outer appearance of battery B (a battery cell). FIG. 13 and FIG. 14 are each a diagram illustrating an example of a temperature at line X-Y in FIG. 12. FIG. 13 illustrates a temperature when battery B is in thermal equilibrium and FIG. 14 illustrates a temperature when battery B is in thermal non-equilibrium. The expression "battery B is in thermal equilibrium" means that battery B is not in operation and battery B is neither charging nor discharging. The expression "battery B is in thermal non-equilibrium" means that battery B is in operation and battery B is either charging or discharging.

When battery B is in thermal non-equilibrium, a temperature at the surface of battery B differs from a temperature inside battery B, as illustrated in FIG. 14. Temperature Temp obtained by temperature measurer 111 is a temperature at the surface of battery B. Consequently, when battery B is in thermal non-equilibrium, temperature Temp is different from the actual internal temperature of battery B.

FIG. 15 is a diagram illustrating the outer appearance of battery pack 101 including batteries B1 through B8. FIG. 16 and FIG. 17 are each a diagram illustrating an example of temperatures at line X-Y in FIG. 15. FIG. 16 illustrates the temperatures when battery pack 101 is in thermal equilibrium, and FIG. 17 illustrates the temperatures when battery pack 101 is in thermal non-equilibrium.

When battery pack 101 is in thermal non-equilibrium, the temperature of battery B4 placed near the center of battery pack 101 is different from a temperature at the surface of battery pack 101, as illustrated in FIG. 17. Temperature Temp obtained by temperature measurer 111 is a temperature at the surface of battery pack 101. Consequently, when battery pack 101 is in thermal non-equilibrium, temperature Temp is different from the actual internal temperature of battery pack 101.

Battery anomaly detection device 100 may therefore detect an anomalous cell using AC impedances when battery pack 101 is in thermal equilibrium. FIG. 18 is a flowchart illustrating a battery anomaly detection process performed by battery anomaly detection device 100 according to the present embodiment. The process illustrated in FIG. 18 results from adding step S110 to the process illustrated in FIG. 2.

Battery anomaly detection device 100 determines whether battery pack 101 is in thermal equilibrium (S110). When battery pack 101 is in thermal equilibrium (Yes in S110), battery anomaly detection device 100 measures AC impedances of battery cells in battery pack 101 (S101) and detects an anomalous cell using the AC impedances (S102 through S108).

The expression "when battery pack 101 is in thermal equilibrium" means, for example, that current is not flowing through load 102 and battery pack 101 is chemically stable. For example, when a predetermined time (e.g., approximately an hour) has elapsed after charge or discharge of battery pack 101, battery anomaly detection device 100 determines that battery pack 101 is in thermal equilibrium. Whether batteries are charging or discharging may be determined based on a control signal that is provided from higher-level controller 130 and indicates operation or non-operation of batteries. The control signal may be, for example, a signal for controlling relay 103.

With the above configuration, since temperature Temp gets closer to the internal temperature of battery B, a reference range associated with a temperature can be appropriately selected, and this in turn can enhance anomaly detection accuracy.

Also in the case of using the anomaly detection process described in Embodiment 1 or 2, AC impedances of battery cells in a battery pack may be measured when the battery pack is in thermal equilibrium.

The AC impedances may be measured not only when the battery pack is in thermal equilibrium, but also when the battery pack is in a specific battery state. FIG. 19 is a flowchart illustrating a battery anomaly detection process in such a case. The process illustrated in FIG. 19 results from adding step S111 to the process illustrated in FIG. 2.

Battery anomaly detection device 100 determines whether the battery state of battery pack 101 is a predetermined state (S111). When the battery state is the predetermined state (Yes in S111), battery anomaly detection device 100 measures AC impedances of battery cells in battery pack 101 (S101) and detects an anomalous cell using the AC impedances (S102 through S108).

The battery state here includes at least one of the temperature, voltage, or SOC of battery pack 101 (battery B). Since this allows measuring AC impedances in the same state, variance in AC impedances depending on the battery state of battery pack 101 can be reduced. For example, in the above-described method according to Embodiment 2, since a measurement condition used in the past can be used for the current measurement condition, anomaly detection accuracy can be enhanced.

As described above, anomaly determiner 120B according to the present embodiment determines, as the reference range, a range corresponding to the current first battery state of the battery cell (battery B) among a plurality of ranges associated in advance with a plurality of first battery states. The plurality of first battery states each include at least one of the temperature, voltage, or SOC of the battery cell.

For example, AC impedance measurer 110 measures the AC impedance of a battery cell when the battery cell is in thermal equilibrium.

For example, AC impedance measurer 110 measures the AC impedance of a battery cell when the battery cell is in a second battery state that is predetermined. The second battery state includes at least one of the temperature, voltage, or SOC of the battery cell.

### [Embodiment 4]

The present embodiment describes a variation of the anomalous cell determination method according to Embodiment 3. FIG. 20 is a block diagram illustrating anomaly determiner 120C according to the present embodiment. Battery anomaly detection device 100 according to the present embodiment includes anomaly determiner 120C illustrated in FIG. 20 instead of anomaly determiner 120B. Anomaly determiner 120C illustrated in FIG. 20 is different from anomaly determiner 120B according to Embodiment 3 in that reference range table 208, which is stored in storage 206B, is obtained from server device 300 that is externally provided.

FIG. 21 is a diagram illustrating the outline of battery anomaly detection system 200 according to the present embodiment. As illustrated in FIG. 21, battery anomaly detection system 200 includes battery anomaly detection device 100 and server device 300. Server device 300 is provided in a location separate from the location of battery anomaly detection device 100. Server device 300 is a so-called cloud server. Server device 300 is connected to, for example, another server device via cloud network 301 for communication.

Battery anomaly detection device 100, which is mounted in, for example, vehicle 400 such as an EV, monitors battery pack 101 for driving motor 401 of vehicle 400 and estimates the state of battery pack 101. Communicator 122 included in battery anomaly detection device 100 receives, for example, reference range table 208 corresponding to the current state of battery pack 101 from server device 300 via wireless communication. A relay device, which is not shown in FIG. 1, may be interposed between communicator 122 and server device 300. Communication performed by communicator 122 may be wireless or wired. The communication standard of communication performed by communicator 122 is not particularly limited.

For example, server device 300 manages the state of degradation (SOC or SOH, for instance) of battery pack 101. Battery anomaly detection device 100 receives reference range table 208 corresponding to the current state of degradation of battery pack 101 from server device 300, and with the use of received reference range table 208, sets a reference range using the method described in Embodiment 3. Battery anomaly detection device 100 may receive a reference range corresponding to the current battery state of battery pack 101 from server device 300, and detect an anomalous cell using the received reference range. In this case, battery anomaly detection device 100 may transmit the current battery state of battery pack 101 to server device 300 and receive a reference range corresponding to the battery state from server device 300. Battery anomaly detection device 100 may receive a reference value instead of a reference range.

As described above, battery anomaly detection device 100 further includes communicator 122 that communicates with server device 300 via a communication network, and a reference range is obtained from server device 300. This allows performing determination that reflects the state of degradation of battery B, making it possible to enhance anomaly detection accuracy.

Although embodiments of the present disclosure have been described above, the present disclosure is not limited to the above-described embodiments.

In each of the above-described embodiments, a battery anomaly detection device and a battery anomaly detection system that target batteries used in vehicles such as EVs have been described, but the battery anomaly detection device and the battery anomaly detection system may target batteries used in any application.

The above has described examples of an anomalous cell determination method in the embodiments, but the examples may be combined. For example, battery anomaly detection device 100 may perform determination using any of the anomalous cell determination methods described in the embodiments, and determine that battery B that has been determined as being an anomalous cell using at least one of the methods is an anomalous cell.

Each of the circuit configurations described in the above-described embodiments is one example and the present disclosure is not limited to the circuit configurations described above. In other words, a circuit that can implement the characteristic features of the present disclosure, like any one of the circuit configurations described above, is also included in the present disclosure. For example, a circuit in which elements such as a switching element (a transistor), a resistor element, and a capacitor element are connected in series or in parallel to a given element in a range that can implement the same functions as those of any one of the circuit configurations described above is also included in the present disclosure.

In the above-described embodiment, elements included in an integrated circuit are implemented by hardware. However, some of the elements in the integrated circuit may be implemented by executing a software program suitable for the elements or by a program executor such as a central processing unit (CPU) or a processor reading and executing a software program recorded on a recording medium such as a hard disk or a semiconductor memory.

In the above embodiments, a process performed by a specific processing unit may be performed by a different processing unit. In an operation described in each of the above-described embodiments, the order of processes may be changed or processes may be performed in parallel.

Other embodiments obtained by various modifications of the embodiments that may be conceived by persons skilled in the art, as well as embodiments resulting from arbitrary combinations of elements and functions from different embodiments that do not depart from the essence of the present disclosure are also included in the present disclosure.

### [Reference Signs List]

- 100: battery anomaly detection device
- 101: battery pack
- 102: load
- 103: relay
- 104: transistor
- 105: reference resistance
- 106: load resistance
- 107: temperature sensor
- 110: AC impedance measurer
- 111: temperature measurer
- 113: current measurer
- 114: signal generator
- 115: voltage measurer
- 117: timing generator
- 118: AC impedance calculator
- 120,: 120A, 120B, 120C anomaly determiner
- 121: controller
- 122: communicator
- 130: higher-level controller
- 200: battery anomaly detection system
- 201: input unit
- 202: comparer
- 203: determiner
- 204: input/output unit
- 205, 205A, 205B: reference range calculator
- 206, 206B: storage
- 207: previously-measured AC impedances
- 208: reference range table
- 300: server device
- 301: cloud network
- 400: vehicle
- 401: motor
- B, B1-B8: battery

## Claims

1. A battery anomaly detection device comprising:
an alternating-current (AC) impedance measurer that measures an AC impedance of a battery cell; and
an anomaly determiner that determines whether the AC impedance is within a reference range, and when the AC impedance is not within the reference range, determines that the battery cell is an anomalous cell.

2. The battery anomaly detection device according to claim 1, wherein
the AC impedance measurer measures an AC impedance of each of a plurality of battery cells that include the battery cell and are directly connected to each other, and
the anomaly determiner:
calculates the reference range from the AC impedances measured; and
determines whether each of the AC impedances is within the reference range, and determines that the battery cell whose AC impedance is not within the reference range is an anomalous cell.

3. The battery anomaly detection device according to claim 2, wherein
the anomaly determiner:
excludes a largest value and a smallest value from the AC impedances measured;
calculates an average value of remaining AC impedances after the exclusion of the largest value and the smallest value; and
calculates the reference range based on the average value.

4. The battery anomaly detection device according to claim 1, further comprising:
storage that stores a previously-measured AC impedance, wherein
the anomaly determiner determines the reference range based on the previously-measured AC impedance.

5. The battery anomaly detection device according to claim 1, wherein
the anomaly determiner determines, as the reference range, a range corresponding to a current first battery state of the battery cell among a plurality of ranges that are associated in advance with a plurality of first battery states, and
the plurality of first battery states each include at least one of a temperature, a voltage, or a state of charge (SOC) of the battery cell.

6. The battery anomaly detection device according to claim 1, further comprising:
a communicator that communicates with a server device via a communication network, wherein
the reference range is obtained from the server device.

7. The battery anomaly detection device according to any one of claims 1 to 6, wherein
the AC impedance measurer measures the AC impedance of the battery cell when the battery cell is in thermal equilibrium.

8. The battery anomaly detection device according to any one of claims 1 to 7, wherein
the AC impedance measurer measures the AC impedance of the battery cell when the battery cell is in a second battery state that is predetermined, and
the second battery state includes at least one of a temperature, a voltage, or a state of charge (SOC) of the battery cell.

9. A battery anomaly detection method comprising:
measuring an alternating-current (AC) impedance of a battery cell;
determining whether the AC impedance is within a reference range; and
when the AC impedance is not within the reference range, determining that the battery cell is an anomalous cell.
